# EUROPÄISCHE PATENTSCHRIFT

(11) **EP 2 759 060 B1**
(45) Veröffentlichungstag und Bekanntmachung des Hinweises auf die Patenterteilung: **07.11.2018**
(21) Anmeldenummer: 12775630.2
(22) Anmeldetag: 18.09.2012
(51) Int. Cl.: H03K 17/96

(54) **BEDIENVORRICHTUNG, BEISPIELSWEISE EIN MENSCH-MASCHINE-INTERFACE, INSBESONDERE FÜR EINE FAHRZEUGKOMPONENTE**
OPERATING DEVICE, SUCH AS A HUMAN-MACHINE INTERFACE, IN PARTICULAR FOR A VEHICLE COMPONENT
DISPOSITIF DE COMMANDE, PAR EXEMPLE INTERFACE HOMME-MACHINE, EN PARTICULIER POUR UN COMPOSANT DE VÉHICULE

(30) Priorität: 22.09.2011 DE 102011083235
(43) Veröffentlichungstag der Anmeldung: 30.07.2014
(73) Patentinhaber: Behr-Hella Thermocontrol GmbH, 70469 Stuttgart (DE)
(72) Erfinder: KLEINE-HOLLENHORST, Holger, 59556 Lippstadt-Cappel (DE); STICH, Bernd, 33142 Büren (DE); SIEBERT, Rainer, 59597 Erwitte (DE)
(74) Vertreter: dompatent von Kreisler Selting Werner - Partnerschaft von Patent- und Rechtsanwälten mbB
(86) Internationale Anmeldenummer: PCT/EP2012/068336
(87) Internationale Veröffentlichungsnummer: WO 2013/041520

(56) Entgegenhaltungen:
- EP-A1- 2 280 484
- EP-A1- 2 355 356
- EP-A2- 1 672 797
- WO-A1-2008/006212
- DE-A1-102009 021 033
- DE-U1-202005 007 480

## Beschreibung

Diese Anmeldung nimmt die Priorität der deutschen Patentanmeldung 10 2011 083 235.1 vom 22. September 2011 in Anspruch.

Die Erfindung betrifft eine Bedienvorrichtung oder allgemein ausgedrückt ein Mensch-Maschine-Interface, und zwar insbesondere in der Anwendung bei einer Fahrzeugkomponente, also eine Bedienvorrichtung für ein Mensch-Maschine-Interface einer Fahrzeugkomponente.

Für die verschiedensten elektrischen Geräte existieren Bedienvorrichtungen zur manuellen Einstellung und Veränderung der Betriebsparameter des Geräts. Insbesondere im Automotive-Bereich sowie beispielsweise auch bei anderen elektronischen Geräten (PDA, Handy, Tablet-Computer, Palmtops und Laptops) kann es von Vorteil sein, auf einer Anzeigevorrichtung ein beispielsweise Menü für die Einstellungsoptionen darzustellen, wenn sich der Bediener mit beispielsweise einem Finger seiner Hand der Bedienvorrichtung nähert. In diesem Zusammenhang ist es bekannt, kapazitive Näherungssensoren einzusetzen, die Elektroden aufweisen, welche der kapazitiven Erfassung eines sich beispielsweise einer Taste annähernden Objekts wie beispielsweise einer Hand oder eines Fingers einer Hand dienen. Die kapazitiv wirkende Elektrode eines derartigen Näherungssensors sollte möglichst nahe an der Vorderseite bzw. an der Vorderseite eines Tastenkörpers angeordnet sein, um die Annäherung eines Objekts zuverlässig erkennen zu können. Ein Beispiel für eine Betätigungstaste mit einem in dieser angeordneten kapazitiven Näherungssensor ist in DE-A-10 2006 035 837 beschrieben. Die Elektrode ist hierbei als schraubenlinienartiges Federelement ausgebildet, das an der Innenseite der vorderen Wand des Tastenkörpers anliegt.

Weitere Beispiele für Bedienelemente mit Näherungssensorik, bei denen der Näherungssensor innerhalb eines niederdrückbaren Tastenkörpers angeordnet ist, finden sich in DE-A-10 2007 025 564 und EP-A-1 739 839. Auch bei den in diesen Schriften beschriebenen Beispielen wirkt sich die Sensorik auf die zum Niederdrücken der Tasten erforderliche Kraft aus. Zudem besteht eine weitere Schwierigkeit der bisher beschriebenen bekannten Tasten mit kapazitiver Näherungssensorik darin, dass eine Hinterleuchtung des Tastenkörpers bzw. von dessen Vorderwand nur noch eingeschränkt möglich ist, da diesbezüglich die Einbauten in Form der Näherungssensorik Einschränkungen bezüglich der gleichmäßigen Ausleuchtung des Tastenkörpers mit sich bringen.

Ferner ist es aus DE-U-20 2005 002 157 bekannt, bei einem von Hand bedienbaren, feststehenden Berührungsfeld (Touch-Screen oder -Panel) eine kapazitive Näherungssensorik dadurch zu realisieren, dass zwischen dem feststehenden Berührungsfeld und einer mit Abstand unterhalb des Berührungsfeldes angeordneten Trägerplatte eine sich zum Berührungsfeld hin aufweitende schraubenförmige elektrisch leitende Feder angeordnet ist, die unter Kompression zwischen dem Berührungsfeld und der Trägerplatte angeordnet ist und die kapazitive Elektrode des Näherungssensors bildet.

In DE-A-10 2008 029 567 ist ein hinterleuchteter kapazitiver Annäherungssensor beschrieben, bei dem elektrische Leiter von einer eine Hinterleuchtungslichtquelle tragenden Platine zur Rückseite der Vorderwand eines Gehäuses führen. An der Rückseite kontaktieren diese elektrischen Leiter eine leitende kapazitätsbildende Sensorschicht, die hinter der Vorderwand angeordnet ist. Es erfolgt also eine elektrische Verbindung zwischen den elektrischen Leitern und der kapazitätsbildenden Sensorschicht. Auf Grund äußerer Einflüsse kann sich die elektrische Kontaktierung zwischen den elektrischen Leitern und der Sensorschicht im Laufe der Zeit verschlechtern, so dass die Gesamtanordnung schlechtere Eigenschaften aufweisen kann.

Eine weitere Sensorvorrichtung ist in DE-U-201 19 700 beschrieben, während DE-A-103 52 681 eine Bedieneinrichtung zur Bedienung eines Elektrogeräts mit einem Berührungssensor zeigt. Ein Sensorelement, das auf Berührungen anspricht, ist beispielshaft in DE-A-101 23 633 beschrieben. DE-U-20 2007 000 969 zeigt ein Sensorelement für einen kapazitiven Berührungsschalter sowie eine Bedienungseinrichtung. Einen Berührungsschalter mit Sensortaste offenbart-auch DE-U-29 721 212. Schließlich zeigt DE-U-20 2005 007 480 ein berührungssensitives Bedienfeld eines elektrischen Geräts.

Die bekannte kapazitive Näherungssensorik kann einen erhöhten Aufwand an Montage erfordern.

Aus EP-A-2 280 484 ist eine Bedienvorrichtung nach dem Oberbegriff des Anspruchs 1 bekannt.

Aufgabe der Erfindung ist es, eine Bedienvorrichtung mit kapazitiver Näherungssensorik zu schaffen, bei der sowohl der konstruktive Aufwand als auch der Montageaufwand reduziert ist.

Zur Lösung dieser Aufgabe wird mit der Erfindung eine Bedienvorrichtung oder allgemein ausgedrückt ein Mensch-Maschine-Interface, insbesondere für eine Fahrzeugkomponente, vorgeschlagen, wobei die Bedienvorrichtung versehen ist mit den Merkmalen des Anspruchs 1. Einzelne Ausgestaltungen der Erfindung sind Gegenstand der Unteransprüche.

Die erfindungsgemäße Bedienvorrichtung ist mit einer Vorderwand versehen, die auf einer Vorderseite mehrere feststehende Symbolfelder aufweist. Neben diesen feststehenden Symbolfeldern kann die Vorderwand auch noch mit bewegbaren Bedienelementen (Drehknöpfen, Tastern, Schiebeschaltern, Wipp-Tastern) versehen sein.

Ferner weist die Bedienvorrichtung eine kapazitive Näherungssensorik auf, die Elektroden umfasst, welche mit einer Auswerteeinheit elektrisch verbunden sind. Die Elektroden befinden sich nahe den Symbolfeldern und sind diesen jeweils zugeordnet. Die Elektroden sind an der Rückseite der Vorderwand angeordnet, ohne aber notwendigerweise mit der Vorderwand fest verbunden zu sein. Die Auswerteeinheit befindet sich typischerweise auf einer Trägerplatte, die im Regelfall nach Art einer Platine ausgebildet ist und entsprechende mechanische und/oder elektrische/elektronische Bauteile aufweist. Mit Hilfe der nahe den Symbolfeldern angeordneten Elektroden lässt sich eine Veränderung der Kapazität der Elektroden und/oder eine Störung der elektrischen Felder um die Elektroden ermitteln, wenn sich ein Objekt, insbesondere die Hand oder der Finger einer Hand einer Person einem der Symbolfelder nähert. Dadurch lässt sich dieses Symbolfeld identifizieren, um dann auf beispielsweise einem Anzeigeelement der Bedienvorrichtung Informationen anzuzeigen, die mit der durch das betreffende Symbolfeld auswählbaren bzw. einstellbaren Funktion im Zusammenhang stehen.

Die erfindungsgemäße Bedienvorrichtung weist den einzelnen Symbolfeldern zugeordnete Elektrodenträgerelemente auf, die zwischen der Vorderwand und der Trägerplatte angeordnet sind. Diese Elektrodenträgerelemente sind als im Wesentlichen starre Elemente ausgeführt, die beispielsweise aus einem Kunststoffmaterial gefertigt sind. Diese Elektrodenträgerelemente tragen die jeweiligen Elektroden, die an dem zur Rückseite der Vorderwand weisenden (Elektroden-)Ende der Elektrodenträgerelemente angeordnet sind. Das einem Elektrodenende gegenüberliegende Ende eines Elektrodenträgers ist als Kontaktende ausgeführt, das unter Erzeugung eines elektrischen Kontakts an einem Kontaktfeld der Trägerplatte anliegt, welches wiederum über eine Leiterbahn o.dgl. elektrischen Leiter mit der Auswerteeinheit verbunden ist. Das Elektrodenende jedes Elektrodenträgerelements ist als abstehender Berührungsrand ausgebildet, der sich zumindest teilweise um das Symbolfeld herum erstreckt, dem das Elektrodenende zugeordnet ist. Zweckmäßigerweise verläuft der Berührungsrand umlaufend um das Symbolfeld herum und ist geschlossen. Die Elektrode erstreckt sich längs des Berührungsrandes, und zwar zumindest über einen Teilabschnitt desselben. Die Elektrode ist elektrisch verbunden mit dem Kontaktende des Elektrodenträgerelements, so dass dieses einen entsprechenden elektrischen Leiter trägt.

Die kapazitive Näherungssensorik der erfindungsgemäßen Bedienvorrichtung weist also eine kompakt ausgeführte und einfach zu montierende Elektrodenanordnung bzw. -halterung in Form der Elektrodenträgerelemente auf. Jedes Elektrodenträgerelement umfasst dabei mindestens eine Elektrode, den bzw. die elektrischen Leiter zwischen der betreffenden Elektrode und dem Kontaktende des Elektrodenträgerelements sowie einen elektrisch leitenden Bereich am Kontaktende zur elektrischen Kontaktierung eines Kontaktfeldes der Trägerplatte. Mehrere Elektrodenträgerelemente können einstückig zusammengefasst sein, so dass ein gemeinsames Elektrodenträgerelement mit mehreren gegeneinander elektrisch isolierten Elektrodenenden bzw. Elektroden entsteht, die jeweils über getrennte Leiter mit elektrisch voneinander isolierten Kontaktbereichen des Elektrodenträgerelements verbunden sind, welche dann ihrerseits in elektrischem Kontakt zu Kontaktfeldern der Trägerplatte stehen.

Als Klapperschutz sowie zur sicheren elektrischen Kontaktierung der Elektrodenträgerelemente an der Trägerplatte ist gemäß der Erfindung vorgesehen, dass an dem Kontaktende jedes Elektrodenträgerelements mindestens ein integral mit dem Elektrodenträgerelement ausgebildeter Federarm zur elastischen Anlage an der Trägerplatte angeordnet ist. Die federnde Anlage jedes Elektrodenträgerelements an der Rückseite der Vorderwand, wie dies durch den Federarm realisiert wird, ist auch hinsichtlich eines Toleranzausgleichs von Vorteil.

In vorteilhafter Weiterbildung der Erfindung ist vorgesehen, dass jedes Elektrodenträgerelement ein elektrisch isolierendes Trägermaterial aufweist und dass elektrisch leitendes Material für die Elektrode, den elektrischen Leiter und das Kontaktende des Elektrodenträgerelements in dessen Trägermaterial eingebettet und/oder auf dessen Trägermaterial aufgebracht ist. Die elektrisch leitenden Bereiche des elektrisch isolierenden Trägermaterials für die Elektrodenträgerelemente können durch MID- (Molded Interconnect Device) oder LDS (Laserdirektstrukturierung)-Techniken, durch Galvanisierung, Metallisierung oder durch Lackierung mit elektrisch leitenden Materialien hergestellt werden. Es ist auch möglich, die Elektrodenträgerelemente als 2K-Kunststoffelemente auszuführen, und zwar aus einer elektrisch isolierenden Kunststoffkomponente und aus einer elektrisch leitenden Kunststoffkomponente.

Pro Elektrodenträgerelement können mehrere Federarme vorgesehen sein. Zumindest einer dieser Federarme sollte den elektrischen Kontakt zum Kontaktfeld der Trägerplatte herstellen.

In weiterer vorteilhafter Ausgestaltung der Erfindung können die Elektroden-trägerelemente einen sich zwischen der Trägerplatte und der Vorderwand erstreckenden Hohlraum aufweisen, der für eine Hinterleuchtungsfunktion der Symbolfelder genutzt werden kann. Jedem Elektrodenträgerelement ist dabei zweckmäßigerweise eine Hinterleuchtungslichtquelle auf der Trägerplatte zugeordnet, deren Licht durch den Hohlraum hindurch den Bereich hinter einem Symbolfeld ausleuchtet. Die Elektrodenträgerelemente benachbarter Symbolfelder verhindern dabei den Austritt/den Eintritt von Streulicht. Bei der zuvor beschriebenen Ausgestaltung der Erfindung ist also vorgesehen, dass zumindest ein oder mehrere Elektrodenträgerelemente jeweils von einem sich bis zu den Elektroden- und Kontaktenden des betreffenden Elektrodenträgerelements erstreckenden Hohlraum durchzogen ist bzw. sind und dass die Kontaktenden jedes der Elektrodenträgerelemente über einen umlaufenden Berührungsrand an der Rückseite der Vorderwand bzw. an der Trägerplatte anliegen, und dass auf der Trägerplatte in dem von dem Berührungsrand des Elektrodenträgerelements eingeschlossenen Bereich eine Hinterleuchtungslichtquelle zur Hinterleuchtung des dem Elektrodenträgerelement zugeordneten Symbolfelds angeordnet ist.

Anstelle einer (partiellen) Lackierung oder anderweitigen Auftragung von elektrisch leitendem Material auf das Elektrodenträgerelement kann mit Vorteil gemäß einer Weiterbildung der Erfindung auch vorgesehen sein, dass jedes Elektrodenträgerelement als Zweikomponentenbauteil, insbesondere -spritzgussteil ausgebildet ist, wobei die eine Komponente ein elektrisch isolierender Kunststoff und die andere Komponente ein elektrisch leitfähiger Kunststoff ist, aus dem die die Elektrode und deren elektrische Verbindung und Kontaktierung zur Trägerplatte bildenden Bereiche des Elektrodenträgerelements bestehen.

Wie bereits oben kurz erwähnt, können mehrere Elektrodenträgerelemente einstückig ausgebildet sein und auf diese Weise ein gemeinsames Elektrodenträgerelement für mehrere benachbarte bzw. sämtliches Symbolfelder einer Bedienvorrichtung bilden. Bei Ausbildung der Elektrodenträgerelemente als 2K-Bauteil sind dann auch die Verbindungsbereiche 58 zwischen jeweils zwei Elektrodenträgerelementen 20 aus dem elektrisch isolierenden Kunststoff 56.

Die Erfindung wird nachfolgend anhand eines Ausführungsbeispiels und unter Bezugnahme auf die Zeichnung näher erläutert. Im Einzelnen zeigen dabei:
- Fig. 1: eine Draufsicht auf die Vorderseite der Vorderwand einer Bedienvorrichtung,
- Fig. 2: eine Ansicht auf die Bedienvorrichtung bei entfernter Vorderwand und
- Fig. 3: eine perspektivische Teilansicht auf die Rückseite der Vorderwand mit vor dieser angeordneten Elektrodenträgerelementen.

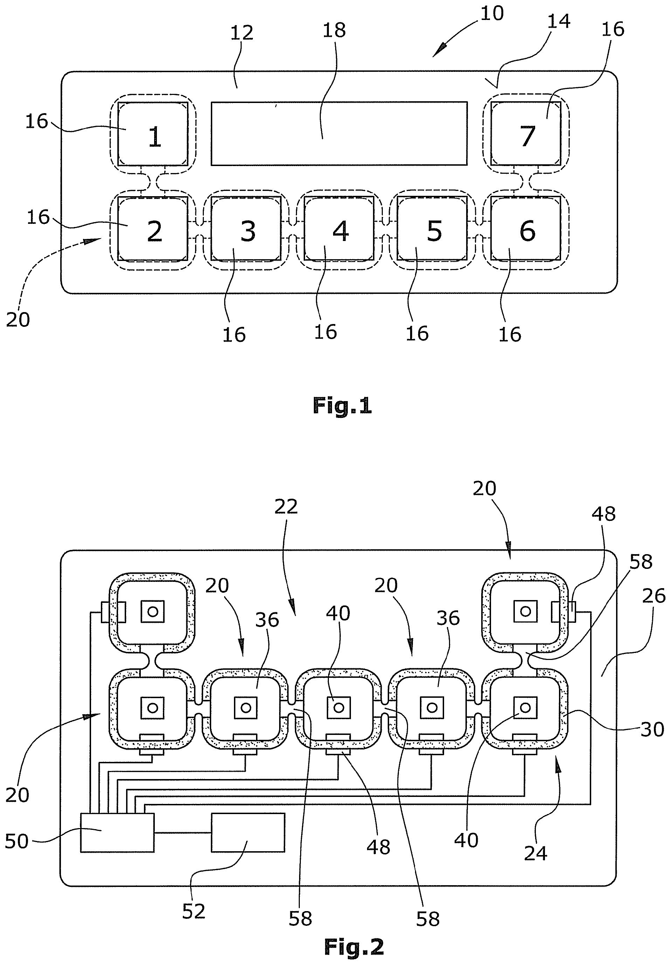

Fig. 1 zeigt in Vorderansicht eine Bedienvorrichtung 10 mit einer Vorderwand 12, auf deren Vorderseite 14 mehrere (im Ausführungsbeispiel sieben) feststehende Symbolfelder 16 angeordnet sind. Ferner weist die Bedienvorrichtung 10 an ihrer Vorderwand 12 ein Display 18 auf.

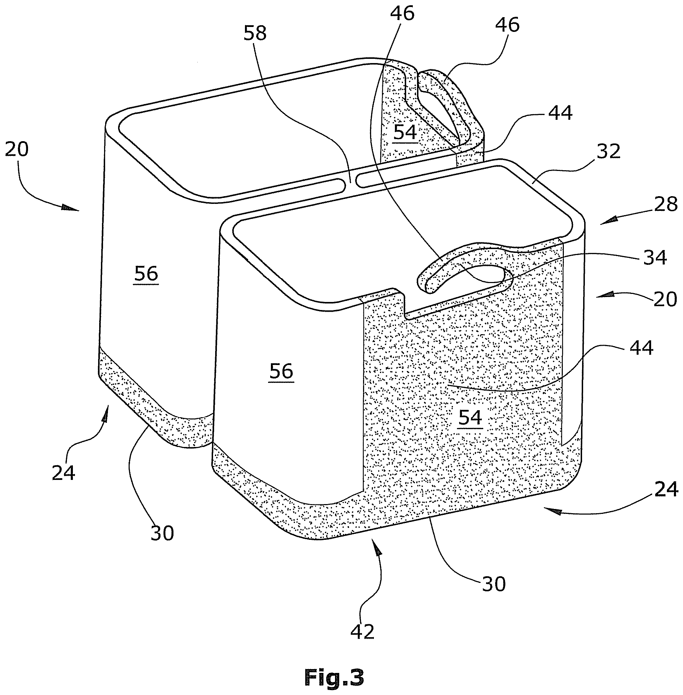

Die Bedienvorrichtung 10 ist mit einer kapazitiven Näherungssensorik für jedes der Symbolfelder 16 versehen. Diese kapazitive Näherungssensorik macht es möglich, die Annäherung beispielsweise eines Fingers einer Hand einer die Bedienvorrichtung 10 bedienenden Person zu erkennen und damit das betreffende Symbolfeld, dem sich der Finger nähert, zu identifizieren. Zu diesem Zweck weist die Bedienvorrichtung 10 mehrere Elektrodenträgerelemente 20 auf, die den einzelnen Symbolfeldern 16 zugeordnet sind und in diesem Ausführungsbeispiel untereinander einstückig verbunden sind und somit ein gemeinsames Trägerelement 22 bilden. Die Ausgestaltung des Trägerelements 22 ist anhand der Fign. 2 und 3 zu erkennen.

Jedes Elektrodenträgerelement 20 weist ein zur Vorderwand 12 weisendes Elektrodenende 24 und ein diesem gegenüberliegendes und zu einer Trägerplatte 26 weisendes Kontaktende 28 auf. Das Elektrodenende 24 ist mit einem in diesem Ausführungsbeispiel umlaufenden, ununterbrochenen Berührungsrand 30 versehen, der sich um ein Symbolfeld 16 erstreckt. An ihren Kontaktenden 28 weisen die Elektrodenträgerelemente 20 ebenfalls Berührungsränder 32 auf. Längs dieser zuletzt genannten Berührungsränder 32 ist jedes Elektrodenträgerelement 20 mit einem Federarm 34 versehen, der über den Berührungsrand 32 hinaus absteht, wie dies beispielsweise in Fig. 3 gezeigt ist.

Wie anhand der Fign.2 und 3 zu erkennen ist, ist jedes Elektrodenträgerelement 20 kanal- bzw. schachtförmig ausgebildet und weist einen Hohlraum 36 auf, der sich vom Kontaktende 28 bis zum Elektrodenende 24 eines Elektrodenträgerelements 20 erstreckt. Die Gesamtanordnung der Elektrodenträgerelemente 20, d.h. das gemeinsame Trägerelement 22 liegt auf der Trägerplatte 26 auf, und zwar mit den Kontaktenden 28 der Elektrodenträgerelemente 20. Die Berührungsränder 30 an den Elektrodenenden 24 der Elektrodenträgerelemente 20 liegen an der Rückseite 38 der Vorderwand 12 an, wie dies beispielsweise in den Fign. 1 und 3 zu erkennen ist. Die jeweiligen Berührungsränder der Elektrodenträgerelemente 20 schließen also einerseits mit der Trägerplatte 26 und andererseits mit der Vorderwand 12 ab, so dass das Licht von Hinterleuchtungslichtquellen 40, die, wie beispielsweise in Fig. 2 gezeigt, auf der Trägerplatte 26 innerhalb der Hohlräume 36 angeordnet sind, zur Hinterleuchtung der jeweiligen Symbolfelder 16 verwendet werden kann, ohne dass Streulicht o.dgl. austreten kann.

Die Elektrodenträgerelemente 20 weisen ein Kunststoffmaterial auf, das elektrisch isolierend ist. An den einzelnen Elektrodenträgerelementen 20 sind elektrisch leitende Elektroden 42 ausgebildet, die sich längs der jeweiligen Berührungsränder 30 und damit längs der Rückseite 38 der Vorderwand 12 um die Symbolfelder 16 herum erstrecken. Die elektrisch leitenden Elektroden 42 sind beispielsweise durch entsprechende Lackierung der Kunststoff-Elektrodenträgerelemente 20 mit elektrisch leitendem Material hergestellt. Von den elektrisch leitenden Bereichen der Elektroden 42 des gemeinsamen Trägerelements 22 erstrecken sich pro Elektrodenträgerelement elektrisch leitende Bereiche 44, und zwar bis zu den Kontaktenden 28. An den Kontaktenden 28 der Elektrodenträgerelemente 20 sind zumindest die Bereiche der integrierten Federarme 34 mit elektrisch leitendem Material versehen, was in Fig. 3 bei 46 gezeigt ist. Wie zu erkennen ist, ist elektrisch leitendes Material an den zur Trägerplatte 26 weisenden Flächen der Federarme 34 vorhanden. In diesen Bereichen liegen die Federarme 34 an Kontaktfeldern 48 der Trägerplatte 26 an, die elektrisch leitend mit einer bei 50 angedeuteten Auswerteeinheit verbunden sind. In der Auswerteeinheit wird infolge der Veränderung der Kapazität der Elektroden 42 bzw. infolge einer Veränderung der elektrischen Felder um die Elektroden 42 herum die Annäherung beispielsweise eines Fingers erkannt, wenn sich dieser einem Symbolfeld 16 nähert. Damit ist aber auch das Symbolfeld 16 identifizierbar. Die Auswerteeinheit 50 kann dann beispielsweise an eine Display-Ansteuereinheit 52 ein entsprechendes Signal zur Ansteuerung des Displays 18 zwecks visueller Informationsanzeige ausgeben.

Alternativ zur partiellen Lackierung des Elektrodenträgerelements 20 mit elektrisch leitfähigem Material (bzw. zur partiellen Aufbringung derartigen Materials in anderer Weise) kann das Elektrodenträgerelement 20 auch als 2K-Spritzgusskunststoffteil ausgebildet sein. Dabei besteht das Elektrodenträgerelement 20 in denjenigen Bereichen, in denen sich die Elektrode 42 und deren elektrisch leitender (Verbindungs-)Bereich 44 sowie das Trägerplattenkontaktfeld-Kontaktierungsende 46 befinden, aus einem (z.B. durch Zusatzstoffe) elektrisch leitfähigem Kunststoffmaterial 54, während der restliche Bereich des Elektrodenträgerelements 20 aus einem elektrisch isolierenden Kunststoffmaterial 56 besteht. Die (z.B. stegartigen) Verbindungsbereiche 58 benachbarter Elektrodenträgerelemente 20 bestehen zwecks Isolation benachbarter Elektroden 42 ebenfalls aus dem elektrisch isolierenden Kunststoffmaterial 56.

### BEZUGSZEICHENLISTE

- 10: Bedienvorrichtung
- 12: Vorderwand der Bedienvorrichtung
- 14: Vorderseite der Vorderrand
- 16: Symbolfelder auf der Vorderwand
- 18: Display der Bedienvorrichtung
- 20: Elektrodenträgerelemente der Näherungssensorik
- 22: gemeinsames Trägerelement
- 24: Elektrodenende
- 26: Trägerplatte
- 28: Kontaktende
- 30: Berührungsrand am Elektrodenende
- 32: Berührungsrand am Kontaktende
- 34: Federarm des Elektrodenträgerelements
- 36: Hohlraum des Elektrodenträgerelements
- 38: Rückseite der Vorderwand
- 40: Hinterleuchtungslichtquelle
- 42: Elektroden der Näherungssensorik
- 44: elektrisch leitender Bereich
- 46: Kontaktierungsende
- 48: Kontaktfelder auf der Trägerplatte
- 50: Auswerteeinheit der Näherungssensorik
- 52: Display-Ansteuereinheit
- 54: elektrisch leitfähiges Kunststoffmaterial
- 56: elektrisch isolierendes Kunststoffmaterial
- 58: Verbindungsbereich zwischen zwei benachbarten Elektrodenträgerelementen

## Patentansprüche

1. Bedienvorrichtung, wie z.B. ein Mensch-Maschine-Interface, insbesondere für eine Fahrzeugkomponente, mit
- einer Vorderwand (12) mit einer mehrere feststehende Symbolfelder (16) aufweisenden Vorderseite (14) und mit einer Rückseite (38),
- einer kapazitiven Näherungssensorik, die einzelne, den Symbolfeldern (16) zugeordnete Elektroden (42) aufweist, welche an der Rückseite (38) der Vorderwand (12) angeordnet sind, und
- einer der Rückseite (38) der Vorderwand (12) zugewandte Trägerplatte (26), die mit Abstand zur Vorderwand (12) angeordnet ist,
- wobei die kapazitive Näherungssensorik zur Identifizierung desjenigen Symbolfeldes (16), dem sich ein Objekt, insbesondere eine Hand oder der Finger einer Hand nähert, eine mit den Elektroden (42) verbundene Auswerteeinheit (50) aufweist,
- wobei zwischen der Vorderwand (12) und der Trägerplatte (26) den einzelnen Symbolfeldern (16) zugeordnete Elektrodenträgerelemente (20) angeordnet sind,
- wobei jedes Elektrodenträgerelement (20) ein der Rückseite (38) der Vorderwand (12) zugewandtes Elektrodenende (24), das mit einer Elektrode (42) versehen ist, und ein gegenüberliegendes Kontaktende (28) aufweist, das ein mit der Auswerteeinheit (50) elektrisch verbundenes Kontaktfeld (48) der Trägerplatte (26) elektrisch kontaktiert,
- wobei das Elektrodenende (24) jedes Elektrodenträgerelements (20) einen sich zumindest teilweise um ein dem Elektrodenträgerelement (20) zugeordnetes Symbolfeld (16) herum erstreckenden, an der Rückseite (38) der Vorderwand (12) anliegenden, abstehenden Berührungsrand (30) aufweist,
- wobei die Elektrode (42) längs des Berührungsrandes (30) des Elektrodenträgerelements (20) ausgebildet ist, ohne zur Vorderwand (12) hin elektrisch angeschlossen zu sein, und
- wobei jedes Elektrodenträgerelement (20) einen elektrisch leitenden Bereich (44) zur elektrischen Verbindung seiner Elektrode (42) mit seinem Kontaktende (28) und damit mit dem Kontaktfeld (48) der Trägerplatte (26) aufweist,
**dadurch gekennzeichnet,**
- **dass** an dem Kontaktende (28) jedes Elektrodenträgerelements (20) mindestens ein integral mit dem Elektrodenträgerelement (20) ausgebildeter Federarm (34) zur elastischen Anlage an der Trägerplatte (26) angeordnet ist.

2. Bedienvorrichtung nach Anspruch 1, **dadurch gekennzeichnet, dass** jedes Elektrodenträgerelement (20) ein elektrisch isolierendes Trägermaterial aufweist und dass elektrisch leitendes Material für die Elektrode (42), den elektrisch leitenden Bereich (44) und das Kontaktende (28) des Elektrodenträgerelements (20) in dessen Trägermaterial eingebettet und/oder auf dessen Trägermaterial aufgebracht ist.

3. Bedienvorrichtung nach Anspruch 1 oder 2, **dadurch gekennzeichnet, dass** der Federarm (34) oder mindestens einer der Federarme (34) elektrisch leitend ist und auf einem Kontaktfeld (48) der Trägerplatte (26) aufliegt.

4. Bedienvorrichtung nach einem der Ansprüche 1 bis 3, **dadurch gekennzeichnet, dass** zumindest ein oder mehrere Elektrodenträgerelemente (20) jeweils von einem sich bis zu den Elektroden- und Kontaktenden (24,28) des betreffenden Elektrodenträgerelements (20) erstreckenden Hohlraum durchzogen ist bzw. sind und dass die Kontaktenden (28) jedes der Elektrodenträgerelemente (20) über einen umlaufenden Berührungsrand (32) an der Rückseite (38) der Vorderwand (12) bzw. an der Trägerplatte (26) anliegen, und dass auf der Trägerplatte (26) in dem von dem Berührungsrand (32) des Elektrodenträgerelements (20) eingeschlossenen Bereich eine Hinterleuchtungslichtquelle (40) zur Hinterleuchtung des dem Elektrodenträgerelement (20) zugeordneten Symbol-felds (16) angeordnet ist.

5. Bedienvorrichtung nach einem der Ansprüche 1 bis 4, **dadurch gekennzeichnet, dass** zumindest zwei Elektrodenträgerelemente (20), die benachbarten Symbolfeldern (16) zugeordnet sind, einstückig ausgebildet sind, wobei ihre Elektroden (42) mit den diesen zugeordneten elektrisch leitenden Bereichen (44) und Kontaktenden (28) jeweils elektrisch isoliert voneinander sind.

6. Bedienvorrichtung nach einem der Ansprüche 1 bis 5, **dadurch gekennzeichnet, dass** jedes Elektrodenträgerelement (20) als Zweikomponentenbauteil, insbesondere -spritzgussteil ausgebildet ist, wobei die eine Komponente ein elektrisch isolierender Kunststoff (56) und die andere Komponente ein elektrisch leitfähiger Kunststoff (54) ist, aus dem die die Elektrode (42) und deren elektrische Verbindung und Kontaktierung zur Trägerplatte bildenden Bereiche des Elektrodenträgerelements (20) bestehen.

7. Bedienvorrichtung nach Anspruch 5 und 6, **dadurch gekennzeichnet, dass** der Verbindungsbereich (58) zwischen jeweils zwei Elektrodenträgerelementen (20) aus dem elektrisch isolierenden Kunststoff (56) besteht.

## Claims

1. An operating device, such as a human-machine interface, in particular for a vehicle component, comprising
- a front wall (12) with a front side (14) including a plurality of fixed symbol fields (16) and with a rear side (38),
- a capacitive proximity sensor system including individual electrodes (42) associated with the symbol fields (16), which electrodes (42) are arranged at the side rear side (38) of the front wall (12), and
- a carrier plate (26) facing the rear side (38) of the front wall (12), which carrier plate (26) is arranged in spaced relationship to the front wall (12),
- wherein the capacitive proximity sensor system comprises an evaluating unit (50) connected with the electrodes (42) for identifying that symbol field (16) which is approached by an object, in particular a hand or a finger of a hand,
- wherein between the front wall (12) and the carrier plate (26) electrode carrier elements (20) associated with the individual symbol fields (16) are arranged,
- wherein each electrode carrier element (20) includes an electrode end (24) facing the rear side (38) of the front wall (12), which electrode end (24) is provided with an electrode (42), and an opposite contact end (28) electrically contacting a contact field (48) of the carrier plate (26) electrically connected with the evaluating unit (50), and
- wherein the electrode end (24) of each electrode carrier element (20) includes a protruding contact edge (30) extending at least partially around the symbol field (16) associated with the electrode carrier element (20) and abutting on the rear side (38) of the front wall (12),
- wherein the electrode (42) is formed along the contact edge (30) of the electrode carrier element (20) without being electrically connected to the front wall (12), and
- wherein each electrode carrier element (20) includes an electrically conducting area (44) for electrical connection of its electrode (42) with its contact end (28) and thus with the contact field (48) of the carrier plate (26),
**characterized in that**
- at the contact end (28) of each electrode carrier element (20) at least one spring arm (34) integrally formed with the electrode carrier element (20) is arranged in a manner elastically abutting on the carrier plate (26).

2. The operating device according to claim 1, **characterized in that** each electrode carrier element (20) comprises an electrically insulating carrier material, and that an electrically conducting material for the electrode (42), the electrically conducting area (44) and the contact end (28) of the electrode carrier element (20) is embedded in its carrier material and/or is applied to its carrier material.

3. The operating device according to claim 1 or 2, **characterized in that** the spring arm (34) or at least one of the spring arms (34) is electrically conducting and abuts on a contact field (48) of the carrier plate (26).

4. The operating device according to any one of claims 1 to 3, **characterized in that** at least one or a plurality of electrode carrier elements (20) is/are traversed by a respective hollow space extending up to the electrode and contact ends (24, 28) of the respective electrode carrier element (20), and that the contact ends (28) of each electrode carrier element (20) abut on the rear side (38) of the front wall (12) and the carrier plate (26), respectively, via a circumferential contact edge (32), and that a backlighting light source (40) for backlighting the symbol field (16) associated with the electrode carrier element (20) is arranged at the carrier plate (26) in the area enclosed by the contact edge (32) of the electrode carrier element (20).

5. The operating device according to any one of claims 1 to 4, **characterized in that** at least two electrode carrier elements (20) associated with adjacent symbol fields (16) are integrally formed, wherein their electrodes (42) with the electrically conducting areas (44) and contact ends (28) associated therewith are respectively electrically insulated from each other.

6. The operating device according to any one of claims 1 to 5, **characterized in that** each electrode carrier element (20) is configured as a two-component part, in particular an injection-molded part, wherein the one component is an electrically insulating plastic material (56) and the other component is an electrically conductive plastic material (54) of which the areas of the electrode carrier element (20) forming the electrode (42) and its electrical connection and contacting to the carrier plate are made.

7. The operating device according to claims 5 and 6, **characterized in that** the connecting area (58) between two respective electrode carrier elements (20) are made of the electrically insulating plastic material (56).

## Revendications

1. Dispositif de commande, par exemple interface homme-machine, en particulier pour un composant de véhicule, comprenant
- une paroi avant (12) avec un côté avant (14) présentant plusieurs champs de symboles fixes (16) et un côté arrière (38),
- un système capteur de proximité capacitif qui présente des électrodes individuelles (42) affectées aux champs de symboles (16), lesquelles électrodes sont agencées sur le côté arrière (38) de la paroi avant (12), et
- une plaque de support (26) orientée vers le côté arrière (38) de la paroi avant (12), laquelle plaque est agencée à distance de la paroi avant (12),
- où le système capteur de proximité capacitif présente, pour identifier le champ de symbole (16) duquel se rapproche un objet, en particulier une main ou le doigt d'une main, une unité d'évaluation (50) reliée aux électrodes (42),
- où des éléments porte-électrodes (20) affectés aux champs symboles individuels (16) sont agencés entre la paroi avant (12) et la plaque de support (26),
- où chaque élément porte-électrode (20) présente une extrémité d'électrode (24) orientée vers le côté arrière (38) de la paroi avant (12), qui est pourvue d'une électrode (42), et une extrémité de contact opposée (28) qui est en contact électrique avec un champ de contact (48) de la plaque de support (26) connecté électriquement à l'unité d'évaluation (50),
- où l'extrémité d'électrode (24) de chaque élément porte-électrode (20) présente un bord de contact éloigné (30) s'étendant au moins en partie autour d'un champ de symbole (16) affecté à l'élément porte-électrode (20), adjacent au côté arrière (38) de la paroi avant (12),
- où l'électrode (42) est formée le long du bord de contact (30) de l'élément porte-électrode (20) sans être connectée électriquement à la paroi avant (12) et
- où chaque élément porte-électrode (20) présente une zone électroconductrice (44) pour connecter électriquement son électrode (42) à son extrémité de contact (28) et donc au champ de contact (48) de la plaque de support (26),
**caractérisé en ce que**
- au moins un bras de ressort (34) formé d'un seul tenant avec l'élément porte-électrode (20) est agencé sur l'extrémité de contact (28) de chaque élément porte-électrode (20) pour une installation élastique sur la plaque de support (26).

2. Dispositif de commande selon la revendication 1, **caractérisé en ce que** chaque élément porte-électrode (20) présente un matériau de support électro-isolant, et **en ce que** le matériau électroconducteur pour l'électrode (42), la zone électroconductrice (44) et l'extrémité de contact (28) de l'élément porte-électrode (20) est noyé dans son matériau de support et/ou appliqué sur son matériau de support.

3. Dispositif de commande selon la revendication 1 ou 2, **caractérisé en ce que** le bras de ressort (34) ou au moins l'un des bras de ressort (34) est électroconducteur et s'applique sur un champ de contact (48) de la plaque de support (26).

4. Dispositif de commande selon l'une des revendications 1 à 3, **caractérisé en ce qu'**au moins un ou plusieurs éléments porte-électrodes (20) est ou sont passés respectivement à travers un espace creux s'étendant jusqu'aux extrémités d'électrode et de contact (24, 28) de l'élément porte-électrode concerné (20), et **en ce que** les extrémités de contact (28) de chacun des éléments porte-électrodes (20) reposent via un bord de contact périphérique (32) sur le côté arrière (38) de la paroi avant (12) ou sur la plaque de support (26), et **en ce qu'**une source de lumière d'éclairage arrière (40) destinée à éclairer le champ de symbole (16) affecté à l'élément porte-électrode (20) est agencé sur la plaque de support (26) dans la zone enserrée par le bord de contact (32) de l'élément porte-électrode (20).

5. Dispositif de commande selon l'une des revendications 1 à 4, **caractérisé en ce qu'**au moins deux éléments porte-électrodes (20), qui sont affectés à des champs de symboles voisins (16), sont formés d'un seul tenant, leurs électrodes (42) avec les zones (44) et les extrémités de contact (28) électroconductrices qui leur sont affectées étant électriquement isolées l'une de l'autre respectivement.

6. Dispositif de commande selon l'une des revendications 1 à 5, **caractérisé en ce que** chaque élément porte-électrode (20) est conçu sous la forme d'une pièce à deux composants, en particulier une pièce moulée par injection, où le premier composant est une matière plastique électro-isolante (56) et l'autre composant une matière plastique électroconductrice (54) dont se composent les zones de l'élément porte-électrode (20) formant les électrodes (42) et leur connexion électrique ainsi que leur contact avec la plaque de support.

7. Dispositif de commande selon les revendications 5 et 6, **caractérisé en ce que** la zone de connexion (58) entre respectivement deux éléments porte-électrodes (20) se compose de la matière plastique électro-isolante (56).
